# EUROPÄISCHE PATENTANMELDUNG

(11) **EP 1 134 744 A2**
(43) Veröffentlichungstag der Anmeldung: **19.09.2001**
(21) Anmeldenummer: 01104151.4
(22) Anmeldetag: 21.02.2001
(51) Int. Cl.: G11C 11/22

(54) **Integrierter Speicher mit Plattenleitungssegmenten**

(30) Priorität: 23.02.2000 DE 10008243
(71) Anmelder: Infineon Technologies AG, 81669 München (DE)
(72) Erfinder: Braun, Georg, 80339 München (DE); Hönigschmid, Heinz, East Fishkill, NY 12524 (US)
(74) Vertreter: Ginzel, Christian

(57) **Zusammenfassung**

Der integrierte Speicher weist Treibereinheiten DRVi auf, über die die Spaltenauswahlleitungen CSLi mit den Plattenleitungssegmenten PLi verbunden sind und die in Abhängigkeit des Potentials der zugehörigen Spaltenauswahlleitungen CSLi sowie der Wortadressen RADR auf den mit ihnen verbundenen Plattenleitungssegmenten PLi Potentiale erzeugen, die für jeden Betriebszustands des Speichers definierte Werte haben.

## Beschreibung

Die Erfindung betrifft einen integrierten Speicher mit Plattenleitungssegmenten gemäß dem Oberbegriff des Anspruchs 1.

Ein derartiger Speicher ist in der US 5 424 976 A beschrieben. Bei diesem Speicher handelt es sich um einen ferroelektrischen Speicher vom Typ FRAM (ferroelectric random access memory). Die Speicherzellen eines FRAMs sind genauso aufgebaut wie Speicherzellen von DRAMS (dynamic random access memories). Das heißt, jede Speicherzelle weist einen Auswahltransistor und einen Speicherkondensator auf, wobei der Speicherkondensator allerdings im Gegensatz zu einem DRAM ein ferroelektrisches Dielektrikum aufweist.

Anhand der oben genannten US 5 424 976 A soll im folgenden grob die Funktionsweise eines solchen Speichers erläutert werden. Die Speicherzellen sind in Kreuzungspunkten von Bitleitungen, Wortleitungen und Plattenleitungssegmenten angeordnet. Die Auswahl mehrerer Speicherzellen, die einer gemeinsamen Spalte zugeordnet sind, die jeweils mehrere der Bitleitungen aufweist, erfolgt durch Aktivierung der zugehörigen Wortleitung sowie ein Pulsen des zugehörigen Plattenleitungssegments. Dabei sind die Plattenleitungssegmente über als Schaltelemente fungierende Transistoren mit Steuerleitungen verbunden, deren Potential von am Speicher anliegenden Spaltenadressen abhängt. Die Gates der Schalttransistoren sind mit derjenigen Wortleitung verbunden, die den Speicherzellen des jeweiligen Plattenleitungssegments zugeordnet ist. Hieraus folgt, dass die Plattenleitung mit dem entsprechenden Plattenleitungssegment verbunden wird, wenn die zugehörige Wortleitung zur Auswahl der entsprechenden Speicherzellen aktiviert wird. In diesem Fall ist der Schalttransistor leitend. Ansonsten ist der Schalttransistor gesperrt, so dass das entsprechende Plattenleitungssegment von der Steuerleitung, die ein definiertes Potential aufweist, abgekoppelt ist. Im abgekoppelten Fall foaten die Plattenleitungssegmente, die mit einer der Elektroden der Speicherkondensatoren verbunden sind, das heißt sie weisen kein definiertes Potential auf.

Der Erfindung liegt die Aufgabe zugrunde, einen integrieten Speicher der beschriebenen Art anzugeben, der weniger fehleranfällig ist als bekannte Speicher.

Diese Aufgabe wird mit einem integrierten Speicher gemäß Anspruch 1 gelöst. Vorteilhafte Aus- und Weiterbildungen sind Gegenstand der abhängigen Ansprüche.

Der erfindungsgemäße integrierte Speicher weist Treibereinheiten auf, über die die Spaltenauswahlleitungen mit den Plattenleitungssegmenten verbunden sind, und die in Abhängigkeit des Potentials der zugehörigen Spaltenauswahlleitungen sowie der Wortadressen auf den mit ihnen verbundenen Plattenleitungssegmenten Potentiale erzeugen, die für jeden Betriebszustand des Speichers definierte Werte haben.

Durch die genannten Merkmale wird ein Floaten der Plattenleitungssegmente verhindert. Hierdurch werden Störeinflüsse auf Grund von Übersprechen von parallel zu den Plattenleitungssegmenten verlaufenden Leitungen, beispielsweise Wortleitungen, auf die Plattenleitungssegmente verhindert. Zu einem Übersprechen kann es insbesondere bei hoch integrierten Speichern kommen, bei denen die Abstände zwischen den entsprechenden Leitungen besonders klein sind. Da das Potential der Plattenleitungssegmente sowohl bei einer Auswahl der mit ihnen verbundenen Speicherzellen als auch dann, wenn die mit ihnen verbundenen Speicherzellen nicht ausgewählt sind, immer auf definierten Werten gehalten wird, findet keine oder wenigstens nur eine sehr geringe Beeinflussung des Potentials der Segmente auf Grund von Übersprechen statt. Beim erfindungsgemäßen Speicher wird das Vorliegen definierter Potentialwerte auf den Plattenleitungssegmenten in jedem Betriebszustand des Speichers durch das Vorsehen der Treibereinheiten erreicht. Eine Treibereinheit erzeugt ein Ausgangssignal, das in Abhängigkeit von Eingangssignalen der Treibereinheit immer definierte Werte annimmt. Die weiter oben zitierte US 5 424 976 zeigt keine derartigen Treibereinheiten, sondern lediglich Schalttransistoren, die im gesperrten Zustand bewirken, dass die mit ihnen verbundenen Plattenleitungssegmente floaten.

Nach einer vorteilhaften Weiterbildung verlaufen die Plattenleitungssegmente parallel zu den Bitleitungen und der Speicher weist Multiplexer auf, die jeweils elektrisch zwischen einer der Treibereinheiten und zweien der Plattenleitungssegmente angeordnet sind, wobei die Multiplexer die Treibereinheiten in Abhängigkeit von Wortadressen mit einem der beiden zugehörigen Plattenleitungssegmente verbinden. Bei dieser Weiterbildung wird also jeweils eine der Treibereinheiten über den zugehörigen Multiplexer zweien der Plattenleitungssegmente zugeordnet. Daher ist lediglich eine geringere Anzahl von Treibereinheiten notwendig, als wenn pro Plattenleitungssegment jeweils eine separate Treibereinheiten vorgesehen wäre. Selbstverständlich kann eine Treibereinheit über einen entsprechenden Multiplexer auch einer größeren Anzahl von Plattenleitungssegmenten zugeordnet werden.

Nach einer anderer Weiterbildung der Erfindung sind die Plattenleitungssegmente in einer ersten Verdrahtungsebene angeordnet und in Richtung der Wortleitungen durch Trennbereiche voneinander getrennt. Weiterhin sind leitungsförmige Strukturen vorgesehen, die in einer zweiten Verdrahtungsebene senkrecht zu den Wortleitungen in regelmäßigen Abständen zueinander angeordnet sind. Dabei sind die Bitleitungen durch diejenigen leitungsförmigen Strukturen gebildet, die parallel zu den in der ersten Verdrahtungsebene verlaufenden Plattenleitungssegmenten angeordnet sind, während diejenigen leitungsförmigen Strukturen, die parallel zu den in der ersten Verdrahtungsebene verlaufenden Trennbereichen angeordnet sind, Dummystrukturen sind, die mit keiner der Speicherzellen verbunden sind.

Bei dieser Weiterbildung gewährleisten die in regelmäßigen Abständen in der zweiten Verdrahtungsebene angeordneten leitungsförmigen Strukturen eine gleichmäßige und somit technologisch unproblematische Herstellung. Dabei wird jedoch nicht jede leitungsförmige Struktur als Bitleitung genutzt, sondern nur diejenigen leitungsförmigen Strukturen, denen in der ersten Verdrahtungsebene ein zugehöriges Plattenleitungssegment zugeordnet ist. Die übrigen leitungsförmigen Strukturen, die keine Bitleitungen bilden, dienen lediglich zur Vereinfachung des Herstellprozesses und sind daher sogenannte "Dummystrukturen", die keinerlei elektrischer Funktion in der fertiggestellten integrierte Schaltung dienen.

Besonders vorteilhaft ist es bei der soeben beschriebenen Weiterbildung, wenn in der zweiten Verdrahtungsebene, parallel zu jedem Trennbereich jeweils genau nur eine einzelne der Dummystrukturen angeordnet ist, die zwei Gruppen benachbarter Bitleitungen voneinander trennt. Diese Lösung sieht also relativ schmale Trennbereiche zwischen den Plattenleitungssegmenten vor, denen in der zweiten Verdrahtungsebene lediglich eine der in regelmäßigen Abständen zueinander angeordneten leitungsförmigen Strukturen zugeordnet sind. So ergibt sich ein möglichst kompakter Aufbau des integrierten Speichers.

Die Erfindung wird im folgenden an Hand der in den Figuren dargestellten Ausführungsbeispielen näher erläutert. Es zeigen:
Figur 1 ein erstes Ausführungsbeispiel des integrierten Speichers,
Figur 2 eine Treibereinheit des in Figur 1 dargestellten Speichers,
Figur 3 eine Speicherzelle des in Figur 1 dargestellten Speichers,
Figur 4 das Layout eines weiteren Ausführungsbeispiels des erfindungsgemäßen Speichers in der Darstellung mehrerer benachbarter Zellenfelder,
Figur 5 das Layout mehrerer benachbarter Wortleitungen, Bitleitungen und Plattenleitungssegmente und
Figur 6 eine Treibereinheit mit zugehörigem Multiplexer für den Speicher des in Figur 4 dargestellten Ausführungsbeispiels.

Die Erfindung eignet sich zur Anwendung bei allen Speichern, die die Merkmale des Oberbegriffs des Anspruchs 1 aufweisen, das heißt Speicherzellen, die mit Bitleitungen, Wortleitungen und Plattenleitungssegmenten verbunden sind. Im folgenden wird die Erfindung jedoch nur an Hand von Ausführungsbeispielen erläutert, die integrierte Speicher vom Typ FRAM betreffen.

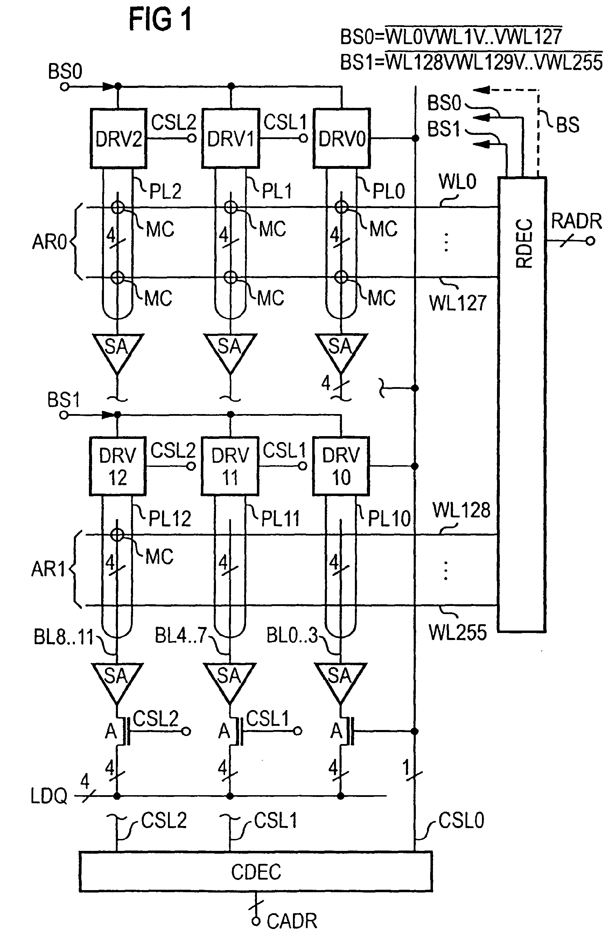

Figur 1 zeigt einen integrierten Speicher mit einem Spaltendecoder CDEC, der in Abhängigkeit von anliegenden Spaltenadressen CADR Spaltenauswahlleitungen CSLi aktiviert und mit einem Zeilendecoder RDEC, der in Abhängigkeit von Zeilenadressen RADR Wortleitungen WLi aktiviert. Der Speicher weist in Zellenfeldern AR0, AR1 angeordnete Speicherzellen MC auf, die sich in Kreuzungspunkten von Bitleitungen BLi, den Wortleitung WLi und Plattenleitungssegmenten PLi befinden. Die Plattenleitungssegmente PLi sind in Figur 1 als verbreiterte Streifen eingezeichnet.

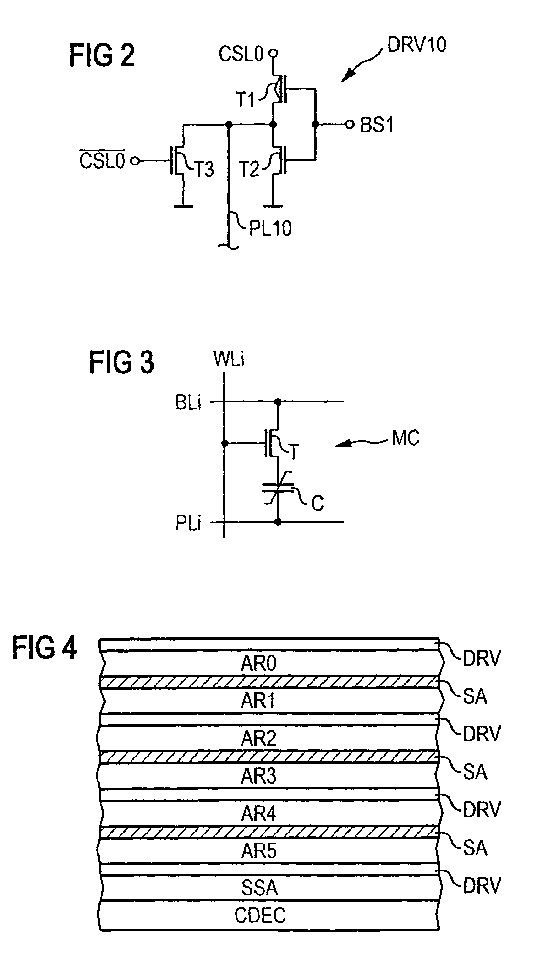

Figur 3 zeigt den Aufbau einer der Speicherzelle MC aus Figur 1. Sie weist einen Auswahltransistor T und einen Speicherkondensator C mit ferroelektischem Dielektrikum auf. Die der Speicherzelle MC zugeordnete Bitleitung BL ist über die steuerbare Strecke des Transistors T mit einer der Elektroden des Speicherkondensators C verbunden. Die andere Elektrode des Speicherkondensators C ist mit dem der Speicherzelle zugeordneten Plattenleitungssegment PLi verbunden. Das Gate des Auswahltransistors T ist mit der zugehörigen Wortleitung WLi verbunden.

Beim Speicher gemäß Figur 1 sind jeweils vier der Bitleitungen BL0..3, BL4..7, BL8..11 einer gemeinsamen Spalte zugeordnet. Alle vier Bitleitungen einer Spalte sind über ein zugehöriges der Spaltenauswahlsignale CSLi über Transistoren A auswählbar. Jede Bitleitung BLi ist über einen zugehörigen Leseverstärker SA und den entsprechenden Transistor A mit einer von vier lokalen Datenleitungen LDQ verbunden, über die Daten von und nach außerhalb des Speichers übertragbar sind. Die Gates der Transistoren A sind mit der entsprechenden Spaltenauswahlleitung CSLi verbunden. In der Praxis sind jedem Leseverstärker SA jeweils zwei Bitleitungen BLi zugeordnet, die ein gemeinsames Bitleitungspaar bilden. Zur Vereinfachung der Darstellung wurden in Figur 1 jeweils die zweiten Bitleitungen jedes Bitleitungspaares nicht eingezeichnet. Zudem wurden die Transistoren A sowie die lokalen Datenleitungen LDQ nur für das untere Speicherzellefeld AR1 dargestellt.

In Figur 1 sind die Spaltenauswahlleitungen CSLi über je eine Treibereinheit DRVi mit jeweils einem der Plattenleitungssegmente PLi in jedem Speicherzellenfeld ARi verbunden. Jeder Treibereinheit DRVi wird außerdem ein Blockauswahlsignal BS0, BS1 zugeführt. Für jedes Zellenfeld AR0, AR1 ist jeweils ein Blockauswahlsignal BS0, BS1 vorgesehen. Die Blockauswahlsignale BS0, BS1 werden ebenfalls vom Zeilendecoder RDEC in Abhängigkeit der Zeilenadressen RADR erzeugt. Dabei entspricht das Blockauswahlsignal BS0 des oberen Zellenfeldes AR0 einer logischen NOR-Verknüpfung der diesem Zellenfeld AR0 zugeordneten Wortleitungssignale WL0 bis WL127. Ebenso ist das dem unteren Zellenfeld AR1 zugeordnete Blockauswahlsignal BS1 eine logische NOR-Verknüpfung der diesem Zellenfeld AR1 zugeordneten Wortleitungssignal WL128 bis WL255. Das bedeutet, dass das entsprechende Blockauswahlsignal BS0,BS1 immer dann einen hohen Pegel annimmt, wenn keine der zugehörigen Wortleitungen WL0 bis WL127 bzw. WL128 bis WL255 einen hohen Pegel aufweist.

Figur 2 zeigt den Aufbau einer der Treibereinheiten DRVi aus Figur 1. Dargestellt ist beispielhaft die Treibereinheit DRV10, die dem unteren Zellenfeld AR1 in Figur 1 zugeordnet ist. Die zugehörige Spaltenauswahlleitung CSL0 ist über einen ersten Transistor T1 vom P-Kanal-Typ mit dem zugehörigen Plattenleitungssegment PL10 verbunden. Das Plattenleitungssegment PL10 ist außerdem über einen zweiten Transistor T2 vom N-Kanal-Typ mit Masse verbunden. Parallel zum zweiten Transistor T2 ist ein dritter Transistor T3 vom N-Kanal-Typ angeordnet. Die Gates des ersten und zweiten Transistors T1, T2 sind mit dem zugehörigen Blockauswahlsignal BS1 verbunden. Das Gate des dritten Transistors T3 ist mit einer inversen Spaltenauswahlleitung /CSL0 verbunden.

In Figur 1 ist die in Figur 2 dargestellte inverse Spaltenauswahlleitung /CSL0 aus Gründen der Übersichtlichkeit nicht eingezeichnet worden. Jeder der Spaltenauswahlleitungen /CSLi in Figur 1 ist jeweils eine derartige parallel zu ihr verlaufende inverse Spaltenauswahlleitung /CSLi zugeordnet, die zu jedem Zeitpunkt ein Potential aufweist, das gegenüber demjenigen der zugehörigen Spaltenauswahlleitung invertiert ist. Bei anderen Ausführungsbeispielen der Erfindung kann dieses invertierte Potential auch lokal in jedem Speicherzellenfeld ARi erzeugt werden, so dass die inversen Spaltenauswahlleitungen /CSLi relativ kurz dimensioniert werden können.

Figur 2 ist zu entnehmen, dass ein Plattenleitungssegment PL10 nur dann einen hohen Pegel aufweist, wenn das zugehörige Blockauswahlsignal BS1 einen niedrigen Pegel aufweist und das zugehörige Spaltenauswahlsignal CSL0 einen hohen Pegel aufweist. Das Blockauswahlsignal BS1 weist genau dann einen niedrigen Pegel auf, wenn eine der dem entsprechenden Zellenfeld AR1 zugeordneten Wortleitungen WL128 bis WL255 einen hohen Pegel aufweist. In allen andern Fällen, d.h. wenn entweder das Spaltenauswahlsignal CSL0 einen niedrigen Pegel aufweist oder wenn das Blockauswahlsignal BS1 einen hohen Pegel aufweist (dies ist genau dann der Fall, wenn keine der Wortleitungen WL128 bis WL255 des betreffenden Zellenfeldes AR1 vom Wortleitungsdecoder RDEC aktiviert worden ist), weist das Plattenleitungssegment PL10 einen niedrigen Pegel auf. Bei einem niedrigen Pegel des Plattenleitungssegments PL10 werden die mit diesem verbundenen Speicherzellen MC nicht selektiert, bei einem hohen Pegel werden sie selektiert. Das bedeutet, das sowohl bei Auswahl als auch bei Nichtauswahl einer der Speicherzellen MC das mit dieser verbundene Plattenleitungssegment einen definierten Pegel aufweist und somit niemals floatet.

Figur 4 zeigt das Layout eines weiteren Ausführungsbeispiels der Erfindung, von dem fünf benachbarte Zellenfelder AR0 bis AR5 dargestellt wurden. Bei diesem Ausführungsbeispiel nutzen jeweils zwei benachbarte Zellenfelder AR0 und AR1, AR2 und AR3 sowie AR4 und AR5 jeweils dieselben Leseverstärker SA (sogenanntes shared sense amplifyer concept). Das shared sense amplifyer concept ist dem Fachmann beispielsweise von DRAMs bereits bekannt. Dargestellt sind weiterhin sekundäre Leseverstärker SSA, die zum Verstärken der über die lokalen Datenleitungen LDQ (siehe Figur 1) von den Leseverstärkern SA getriebenen Daten dienen. Außerdem zeigt die Figur 4 die Anordnung des Spaltendecoders CDEC, der zur Erzeugung der Spaltenauswahlsignale CSLi dient, die über die entsprechenden Auswahlleitungen allen sechs Zellenfeldern ARi zugeführt werden. Beim Speicher gemäß Figur 4 sind einige der Treibereinheiten DRV, über die die Spaltenauswahlleitungen CSLi mit den entsprechenden Plattenleitungssegmenten PLi verbunden sind (siehe Figur 1) jeweils zwei benachbarten Zellenfeldern AR1 und AR2, AR3 und AR4 zugeordnet. Die Streifen der Leseverstärker SA und die Streifen der Treibereinheiten DRV sind alternierend zwischen jeweils benachbarten Zellenfeldern ARi angeordnet.

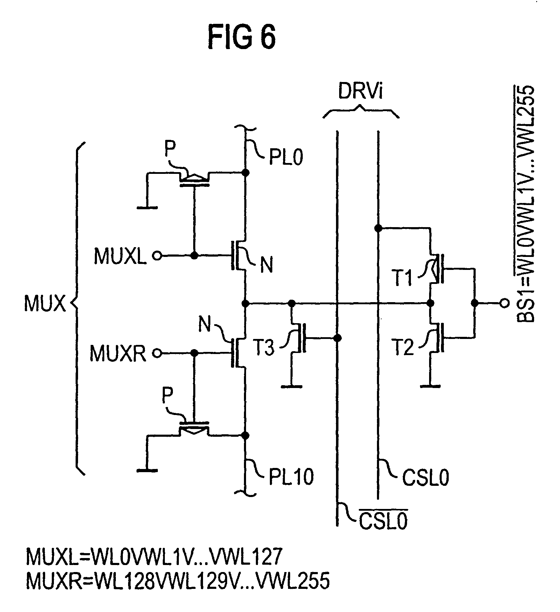

Figur 6 zeigt eine der Treibereinheiten DRV', die beim Speicher gemäß Figur 4 in den mit DRV bezeichneten Streifen angeordnet sind. Jede dieser Treibereinheiten DRV' ist einem Plattenleitungssegment PL0, PL10 in den beiden benachbarten Zellenfeldern AR0, AR1 zugeordnet. Die Treibereinheit DRV', die ebenso wie die in Figur 2 dargestellte Treibereinheit DRV10 aufgebaut ist, ist über einen Multiplexer MUX mit den beiden ihr zugeordneten Plattenleitungssegmenten PLO, PL10 verbunden. Der mit den Drains des ersten und zweiten Transistors T1, T2 verbundene Ausgang der Treibereinheit DRV' ist über je einen N-Kanal-Transistor N mit einem der beiden Plattenleitungssegmente PL0, PL10 verbunden. Beide Plattenleitungssegmente PL0, PL10 sind über je einen P-Kanal-Transistor P mit Masse verbunden. Die Gates des N-Kanal-Transistors N und des P-Kanal-Transistors P, die demselben Plattenleitungssegment PL0 bzw. PL10 zugeordnet sind, sind mit einem von zwei dem Multiplexer MUX zugeordneten Steuersignalen MUXL und MUXR verbunden. Über die Steuersignale MUXL, MUXR, die einer logischen ODER-Verknüpfung der dem jeweiligen Zellenfeld AR0, AR1 zugehörigen Wortleitungssignale WL0 bis WL127 bzw. WL128 bis WL255 entsprechen, erfolgt die Auswahl eines der beiden Plattenleitungssegmente PLO, PL10. Die P-Kanal-Transistoren P in Figur 6 sorgen dafür, dass das jeweils nicht ausgewählte Plattenleitungssegment PL0, PL10 auch dann ein definiertes Potential (nämlich Masse) aufweist, wenn der zugehörige N-Kanal-Transistor N gesperrt ist.

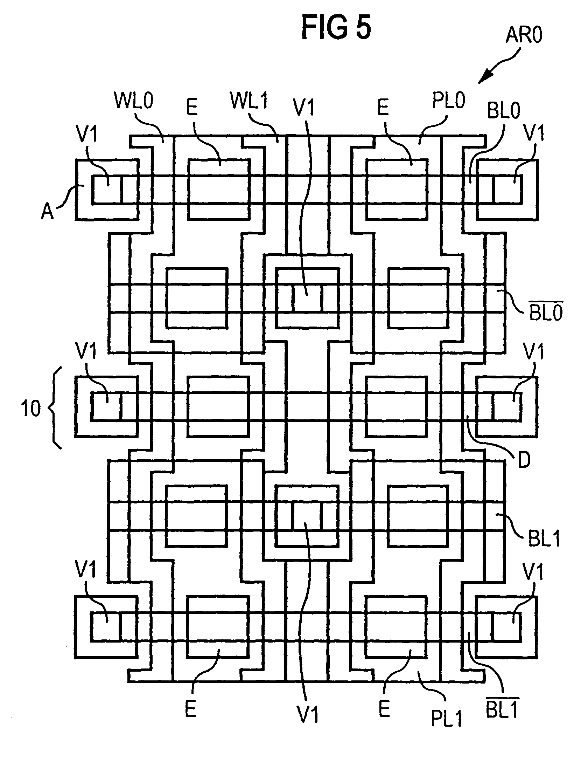

Figur 5 zeigt den Ausschnitt eines Layouts des Zellenfeldes AR0 aus Figur 1. Dargestellt sind die Bitleitungen BLi, die Wortleitungen WLi sowie die Plattenleitungssegmente PLi. Die Plattenleitungssegmente PLi sind in einer ersten Verdrahtungsebene aus Platin angeordnet und verlaufen parallel zu den Bitleitungen BLi, in der Figur 5 von links nach rechts.

Es handelt sich um einen Speicher vom "stacked copocita" Typ. Die Plattenleitungssegmente bilden die oberen Elektroden der Speicherkondensatoren. Die Plattenleitungssegmente PLi sind durch Trennbereiche 10, in denen sich kein Platin in der entsprechenden Verdrahtungsebene befindet, voneinander getrennt. Die Wortleitungen WLi verlaufen senkrecht zu den Bitleitungen BLi und den Plattenleitungssegmenten PLi, in der Figur 5 von oben nach unten. Während die Bitleitungen BLi in einer zweiten Verdrahtungsebene des Speichers angeordnet sind, beispielsweise einer Metallisierungsebene, verlaufen die Wortleitungen WLi in einer dritten Verdrahtungsebene beispielsweise einer Polysiliziumebene.

Die Bitleitungen BLi sind durch in regelmäßigen Abständen parallel zueinander angeordnete leitungsförmige Strukturen in der zweiten Verdrahtungsebene gebildet. Allerdings bildet nicht jede leitungsförmige Struktur eine der Bitleitungen BLi. Vielmehr sind jeweils zwei der Bitleitungen BL0,/BL0 bzw. BL1,/BL1, die ein zusammengehöriges Bitleitungspaar bilden, vom benachbarten Bitleitungspaar durch eine weiterer der leitungsförmigen Strukturen D voneinander getrennt. Diese weiterer leitungsförmige Struktur D befindet sich in der zweiten Verdrahtungsebene parallel zu dem in der ersten Verdrahtungsebene angeordneten Trennbereich 10 zwischen den Plattenleitungssegmenten PLO, PL1. Bei der zusätzlichen leitungsförmigen Struktur D handelt es sich um eine Dummystruktur, die keine elektrische Funktion innerhalb des fertiggestellten Speichers erfüllt.

Die Bitleitungen BLi, /BLi in Figur 5 sowie die Dummystrukturen D sind, wie bereits erwähnt, in regelmäßigen Abständen in der zweiten Verdrahtungsebene angeordnet. Hierdurch wird eine unproblematische Herstellbarkeit dieser Strukturen erreicht, so dass die Bitleitungen mit sehr großer Genauigkeit erzeugt werden können. In Figur 5 wurde lediglich jeweils ein Bitleitungspaar zweier benachbarter Spalten dargestellt, denen unterschiedliche Spaltenadressen zugeordnet sind. Weitere Bitleitungspaare dieser Spalten verlaufen parallel zu den dargestellten Paaren in der zweiten Verdrahtungsebene des Speichers. Die Bitleitungen jeder Spalte sind von den Bitleitungen der benachbarten Spalten durch je eine Dummystruktur voneinander getrennt. Den in der zweiten Verdrahtungsebene angeordneten Bitleitungen jeder Spalte ist jeweils eines der in der ersten Verdrahtungsebene zu ihnen parallel verlaufenden Plattenleitungssegmente zugeordnet.

Figur 5 zeigt auch die Bitleitungskontakte V1, über die die Bitleitungen BLi, /BLi mit dem zugehörigen Auswahltransistor T der Speicherzelle MC verbunden sind. Weiterhin sind die unteren Elektroden E der Speicherkondensatoren C der Speicherzellen MC der Figur 5 zu entnehmen. Bei diesem Ausführungsbeispiel sind die Speicherkondensatoren als Stapelkondensatoren (stacked capacitor) realisiert.

Es ist zu beachten, dass in der Figur 5 die Trennbereiche 10 zwischen den Plattenleitungssegmenten PL0,PL1 eine Breite aufweisen, die einer der leitungsförmigen Strukturen D in der zweiten Verdrahtungsebene entspricht. Hierdurch ist ein sehr kompakter Aufbau des Speichers möglich.

Bei anderen Ausführungsbeispielen der Erfindung können selbstverständlich auch mehr als eine Dummystruktur D zwischen den Bitleitungen der unterschiedlichen Spalten vorgesehen sein.

Die Dummystrukturen D können als "Dummybitleitungen" aufgefasst werden und die mit ihnen verbundenen Kontakte sowie Difusionen als "Dummykontakte" bzw. "Dummydiffusionen", denn sie haben keine elektrische Funktion.

## Patentansprüche

1. Integrierter Speicher
- mit Speicherzellen (MC), die in Kreuzungspunkten von Wortleitungen (WLi), Bitleitungen (BLi) und Plattenleitungssegmenten (PLi) angeordnet sind und die jeweils wenigstens einen Speicherkondensator (C) und einen Auswahltransistor (T) aufweisen,
- dessen Speicherkondensatoren (C) jeweils eine erste Elektrode aufweisen, die mit einem der Plattenleitungssegmente (PLi) verbunden ist, und eine zweite Elektrode, die über den zugehörigen Auswahltransistor (T) mit einer der Bitleitungen (BLi) verbunden sind,
- dessen Auswahltransistoren (T) jeweils einen Steueranschluß aufweisen, der mit einer der Wortleitungen (WLi) verbunden ist,
- dessen Bitleitungen (BLi) zu Spalten (BL0..3, BL4..7) zusammengefaßt sind, die über Spaltenauswahlleitungen (CSLi) auswählbar sind,
- mit einem Spaltendecoder (CDEC) zum Ansteuern der Spaltenauswahlleitungen (CSLi) in Abhängigkeit von Spaltenadressen (CADR),
- mit einem Zeilendecoder (RDEC) zum Ansteuern der Wortleitungen (WLi) in Abhängigkeit von Wortadressen (WADR),
**gekennzeichnet durch**
Treibereinheiten (DRVi), über die die Spaltenauswahlleitungen (CSLi) mit den Plattenleitungssegmenten (PLi) verbunden sind und die in Abhängigkeit des Potentials der zugehörigen Spaltenauswahlleitungen (CSLi) sowie der Wortadressen (RADR) auf den mit ihnen verbundenen Plattenleitungssegmenten (PLi) Potentiale erzeugen, die für jeden Betriebszustand des Speichers definierte Werte haben.

2. Integrierter Speicher nach Anspruch 1,
- dessen Plattenleitungssegmente (PLi) parallel zu den Bitleitungen (BLi) verlaufen,
- mit Multiplexern (MUX), die zwischen jeweils einer der Treibereinheiten (DRV') und zweien der Plattenleitungssegmente (PLi) angeordnet sind,
- wobei die Multiplexer (MUX) die Treibereinheiten (DRV') in Abhängigkeit von Wortadressen (RADR) mit einem der beiden zugehörigen Plattenleitungssegmente verbinden.

3. Integrierter Speicher nach Anspruch 2,
- mit inversen Spaltenauswahlleitungen (/CSLi), die jeweils einer der Spaltenauswahlleitungen (CSLi) zugeordnet sind und deren Potential gegenüber demjenigen der zugehörigen Spaltenauswahlleitung invertiert ist,
- dessen Treibereinheiten (DRV') jeweils einen ersten Transistor (T1) eines ersten Leitungstyps, einen zweiten Transistor (T2) eines zweiten Leitungstyps und einen dritten Transistor (T3) des zweiten Leitungstyps aufweisen,
- dessen erste (T1) und zweite Transistoren (T2) jeweils
- steuerbare Strecken aufweisen, die in einer Reihenschaltung zwischen einem ersten Potential (VCC) und der der jeweiligen Treibereinheit (DRV') zugehörigen Spaltenauswahlleitung (CSLi) angeordnet sind,
- Drains aufweisen, die mit einem Eingang des zugehörigen Multiplexers (MUX) verbunden sind,
- und Steueranschlüsse aufweisen, die mit einem Blockauswahlsignal (BS) verbunden sind, das einer logischen NOR-Verknüpfung von Aktivierungssignalen einer Gruppe der Wortleitungen (WLi) entspricht,
- und dessen dritte Transistoren (T3) jeweils
- eine steuerbare Strecke aufweisen, die zwischen dem ersten Potential (VCC) und dem Eingang des zugehörigen Multiplexers (MUX) angeordnet ist,
- und einen Steuereingang aufweisen, der mit der zugehörigen inversen Spaltenauswahlleitung (/CSLi) verbunden ist.

4. Integrierter Speicher nach Anspruch 1,
- dessen Plattenleitungssegmente (PLi) in einer ersten Verdrahtungsebene angeordnet und in Richtung der Wortleitungen (WLi) durch Trennbereiche (10) voneinander getrennt sind,
- mit leitungsförmigen Strukturen, die in einer zweiten Verdrahtungsebene, im wesentlichen senkrecht zu den Wortleitungen in regelmäßigen Abständen zueinander angeordnet sind,
- dessen Bitleitungen (BLi) durch diejenigen leitungsförmigen Strukturen gebildet sind, die parallel zu den in der ersten Verdrahtungsebene verlaufenden Plattenleitungssegmenten (PLi) angeordnet sind,
- bei dem diejenigen leitungsförmigen Strukturen, die parallel zu den in der ersten Verdrahtungsebene verlaufenden Trennbereichen (10) angeordnet sind, Dummystrukturen (D) sind, die mit keiner der Speicherzellen (MC) verbunden sind.

5. Integrierter Speicher nach Anspruch 4,
bei dem in der zweiten Verdrahtungsebene, parallel zu jedem Trennbereich (10), jeweils genau eine einzelne der Dummystrukturen (D) angeordnet ist, die zwei Gruppen benachbarter Bitleitungen (BLi) voneinander trennt.
